# EUROPEAN PATENT SPECIFICATION

(11) **EP 4 571 835 B1**
(45) Date of publication and mention of the grant of the patent: **08.04.2026**
(21) Application number: 24217241.9
(22) Date of filing: 03.12.2024
(51) Int. Cl.: H10W 90/00, H10W 70/20, H10W 70/40, H10W 40/22

(54) **POWER SEMICONDUCTOR MODULE**
LEISTUNGSHALBLEITERMODUL
MODULE SEMI-CONDUCTEUR DE PUISSANCE

(30) Priority: 12.12.2023 CN 202323400909 U
(43) Date of publication of application: 18.06.2025
(73) Proprietor: ZF Friedrichshafen AG, 88046 Friedrichshafen (DE)
(72) Inventor: Yuan, George, Shanghai 201615 (CN); Xu, Qing, Shanghai 201615 (CN)
(74) Representative: Nowack, Linda

(56) References cited:
- WO-A1-2022/112233
- US-A1- 2020 006 929
- US-A1- 2022 130 808
- US-A1- 2022 406 745

## Description

### TECHNICAL FIELD

The disclosure generally relates to the technical field of semiconductor devices, and in particular to a power module.

### BACKGROUND ART

Semiconductor devices are electronic devices that use the special electrical properties of semiconductor materials to achieve specific functions, and can be used for generating, controlling, receiving, transforming and amplifying signals and performing energy conversion. A power module is a power semiconductor device generally composed of a metal housing, a circuit board and elements. Various elements which may be diodes, transistors, capacitors, inductors or the like are arranged on the circuit board. In addition, depending on different specific applications, the power module may also include other components such as a control circuit and a protective circuit. The power modules of different types and uses may be somewhat different in structure.

With the development of technology, the performance of the power module is constantly improved and optimized. For example, the reliability of the power module is improved by selecting high-reliability elements, optimizing the structure of the power module, enhancing the production process control, etc.; the adaptability of the power module is improved by selecting multi-purpose elements, adding interfaces, etc.; and the power density of the power module may also be increased by using high thermal-conductivity materials, increasing the assembly density, etc., to reduce the size and the weight of the module and improve its power output capability. Optimizing the structure of the power module is an important means to improve the performance of the power module.

Common ways to optimize the structure of the power module in the prior art include: using chip elements instead of traditional in-line elements or selecting smaller-sized chips and devices; and using more integrated chips or devices or optimizing circuits to reduce the number of elements and wiring. The above-mentioned improving methods are mainly to optimize the structure from the aspects of reducing the number of the elements of the power module and reducing the sizes of the elements. In case of the same expenses, the performance and the reliability may be sacrificed to some extent to achieve the purpose of reducing the size of the power module. To guarantee the performance and the reliability of the power module, elements with better performance may be selected, which will inevitably increase the manufacturing cost. Prior art, which refers to this field can be found in US 2022/130808 A1 and US 2020/006929 A1, both disclosing circuit assemblies for electronic power modules. Further prior art can be found in WO 2022/112233 A1 and US 2022/406745 A1.

In particular, US 2022/130808 A1 discloses: a power module, comprising: a power chip, the power chip comprising upper bridge power chips and lower bridge power chips, and a DC+ busbar, an AC busbar and a DC- busbar being arranged substantially parallel to one another; wherein a plurality of upper bridge power chips are linearly distributed parallel to the DC+ busbar and the AC busbar, and a plurality of lower bridge power chips are linearly distributed parallel to the AC busbar and the DC- busbar, wherein the upper bridge power chips and the lower bridge power chips are equal in number; each of the upper bridge power chips has a drain electrically connected to the DC+ busbar, a source electrically connected to the AC busbar and a gate connected to a first gate connector; wherein the first gate connector is immediately adjacent to a connection between the source and the AC busbar; and each of the lower bridge power chips has a drain electrically connected to the AC busbar, a source electrically connected to the DC- busbar and a gate connected to a second gate connector; wherein the second gate connector is immediately adjacent to a connection between the source and the DC- busbar, wherein a drain of each of the upper bridge power chips is electrically connected to the DC+ busbar, a source bonding wire electrically connects each of the upper bridge power chips to the AC busbar, a drain of each of the lower bridge power chips is electrically connected to the AC busbar, and a source bonding wire electrically connects each of the lower bridge power chips to the DC- busbar.

### SUMMARY

A technical problem to be solved by the present invention is to provide a power module which, by optimizing the structural layouts of each busbar and power chip, is higher in integration level while the performance of the power module is ensured, so as to reduce the size of the power module and reduce the manufacturing cost.

In order to solve the above technical problem, a power module according to claim 1 is provided. Said power module includes: a power chip, the power chip comprising upper bridge power chips and lower bridge power chips, and a DC+ busbar, an AC busbar and a DC- busbar being arranged substantially parallel to one another; wherein a plurality of upper bridge power chips are linearly distributed parallel to the DC+ busbar and the AC busbar, and a plurality of lower bridge power chips are linearly distributed parallel to the AC busbar and the DC- busbar, that is, the upper bride power chips and the lower bridge power chips are arranged in length directions of the busbars, where the upper bridge power chips and the lower bridge power chips are equal in number; each of the upper bridge power chips has a drain electrically connected to the DC+ busbar, a source electrically connected to the AC busbar and a gate connected to a first gate busbar; where the first gate busbar is immediately adjacent to a connection between the source and the AC busbar; and each of the lower bridge power chips has a drain electrically connected to the AC busbar, a source electrically connected to the DC- busbar and a gate connected to a second gate busbar; where the second gate busbar is immediately adjacent to a connection between the source and the DC- busbar.

A plurality of drain pads are arranged on the DC+ busbar, a drain bonding wire of each of the upper bridge power chips being electrically connected to a corresponding drain pad; a plurality of source pads are arranged on a side of the AC busbar close to the upper bridge power chips, a source bonding wire of each of the upper bridge power chips being electrically connected to a corresponding source pad; a plurality of drain pads are arranged on a side of the AC busbar close to the lower bridge power chips, a drain bonding wire of each of the lower bridge power chips being electrically connected to a corresponding drain pad; and a plurality of source pads are arranged on the DC- busbar, a source bonding wire of each of the lower bridge power chips being electrically connected to a corresponding source pad.

Further, each of the source pads arranged on at least one of the AC busbar and the DC-busbar includes a plurality of welding blocks, the welding blocks of each of the source pads and the bonding wires led out from the source of a corresponding power chip are equal in number, and one of the bonding wires is electrically connected to each of the welding blocks.

Further, at least one of the first gate busbar and the second gate busbar includes one comb-shaped first sub-busbar and one comb-shaped second sub-busbar; all comb teeth of the first sub-busbar are positioned on the same side, and all comb teeth of the second sub-busbar are positioned on the same side; and the first sub-busbar and the second sub-busbar are arranged opposite to each other, and each of the source pads is positioned between two adjacent comb teeth of the first sub-busbar and also positioned between two adjacent comb teeth of the second sub-busbar.

Optionally, the comb teeth of the first sub-busbar are in interference fit with the comb teeth of the second sub-busbar.

Optionally, each comb tooth of at least one of the first sub-busbar and the second sub-busbar is provided with a gate pad, and a gate bonding wire of the power chip is electrically connected to the gate pad.

Optionally, the power module further includes an enclosure, the enclosure covering the power module and exposing an external conductive area of a conductive element of the power module.

Optionally, a heat dissipation structure is further provided on a back surface of the power module.

Optionally, an insulating resin layer is provided on the back surface of the power module, and the heat dissipation structure is arranged on a surface of the insulating resin layer.

Optionally, the heat dissipation structure is a finned heat dissipation structure.

Compared with the prior art, the disclosure has the following advantages. The DC+ busbar, the AC busbar and the DC- busbar are arranged substantially parallel to one another; each upper bridge power chip has a drain electrically connected to the DC+ busbar, a source electrically connected to the AC busbar and a gate connected to a first gate busbar, where the first gate busbar is immediately adjacent to a connection between the source and AC busbar; and each lower bridge power chip has the drain electrically connected to the AC busbar, the source electrically connected to the DC- busbar, and the gate connected to the second gate busbar, where the second gate busbar is immediately adjacent to a connection between the source and the DC- busbar, which in turn enables the power chip to be arranged compactly, reduces the distance between elements and ultimately reduces the size of the power module.

### BRIEF DESCRIPTION OF THE DRAWINGS

The accompanying drawings are included to provide a further understanding of the present application and are incorporated into and form a part of the present application, show embodiments of the present application, and serve to, together with the description, explain the principles of the present application. In the accompanying drawings:
FIG. 1 is a schematic diagram of an overall structure of a power module according to an embodiment of the present invention;
FIG. 2 is a schematic structural diagram of the power module according to an embodiment of present invention, with a power chip removed;
FIG. 3 is a schematic structural diagram of a gate busbar which can be implemented in an embodiment of the present invention;
FIG. 4 is a schematic structural diagram of the power module according to an embodiment of the present invention, with the gate busbar removed;
FIG. 5 is a schematic structural diagram of the structure shown in FIG. 2, with an enclosure removed;
FIG. 6 is a schematic diagram of the position of a gate pad according to an embodiment of the present invention;
FIG. 7 is a side view of the structure shown in FIG. 6;
FIG. 8 is a schematic diagram of another fitting method of sub-busbars according to an embodiment of the present invention;
FIG. 9 is a schematic diagram of a heat dissipation structure according to an embodiment of the present invention; and
FIG. 10 is a schematic structural diagram of the structure shown in FIG. 9, with the enclosure removed.

Reference signs in the figures are represented as below:
100 - power module;
110 - AC busbar;
120 - enclosure;
130 - DC- busbar;
140 - DC+ busbar;
151 - first gate busbar, 152 second gate busbar, 1501 - first sub-busbar, 1502 - second sub-busbar, 1503 - comb tooth;
160 - power chip, 161 - upper bridge power chip, 162 - lower bridge power chip;
171 - drain pad, 172 - source pad, 173-gate pad;
180 - heat dissipation structure, 181 - fin.

### DETAILED DESCRIPTION OF EMBODIMENTS

To describe technical solutions of embodiments of the present application more clearly, the accompanying drawings required for describing the embodiments will be briefly described below. Obviously, the accompanying drawings described below show merely some of the examples or embodiments of the present application, and those of ordinary skill in the art would also have applied the present application to other similar scenarios according to these accompanying drawings without involving any creative effort. Unless obvious from the language context or otherwise illustrated, the same reference numerals in the drawings represent the same structure or operation.

For ease of description, spatial relative terms such as "over ...", "above ...", "on upper surface of ...", and "on ..." may be used here to describe a spatial position relationship between one device or feature and another device or feature as shown in the figures. It should be understood that the spatial relative terms are intended to encompass different orientations of the device in use or operation, in addition to the orientation of the device described in the figure. For example, if devices in the figure are inverted, the device described as "above" or "over" another device or structure will later be positioned as "below" or "under" another device or structure. Therefore, the exemplary term "above ..." may include both "above ..." and "below ..." orientations. The device may also be positioned in other different ways (rotated by 90 degrees or in other orientations), and the spatial relative descriptions used here are interpreted accordingly.

Furthermore, it should be noted that the use of terms such as "first" and "second" to define parts is merely for ease of facilitating differentiation of the corresponding parts. If not otherwise stated, the above terms have no special meanings and thus cannot be construed as limiting the scope of protection of the present application. Furthermore, although the terms used in the present application are selected from well-known common terms, some of the terms mentioned in the description of the present application may have been selected by the applicant according to his or her determination, and the detailed meaning thereof is described in the relevant section described herein. Furthermore, the present application must be understood, not simply by the actual terms used but also by the meanings encompassed by each term.

It should be understood that when a component is said to be "located on another component", "connected to another component", "coupled to another component", or "in contact with another component", it may be directly located on the other component, connected or coupled to the other component, or in contact with the other component, or there may be an intervening component. In contrast, when a component is said to be "directly located on another component", "directly connected to another component", "directly coupled to another component", or "in direct contact with another component", there is no intervening component. Similarly, when a first component is said to be "in electrical contact with" or "electrically coupled to" a second component, there is an electrical path between the first component and the second component that allows the flow of current. The electrical path can include a capacitor, coupled inductors, and/or other components that allow the flow of current, even without direct contact between conductive components.

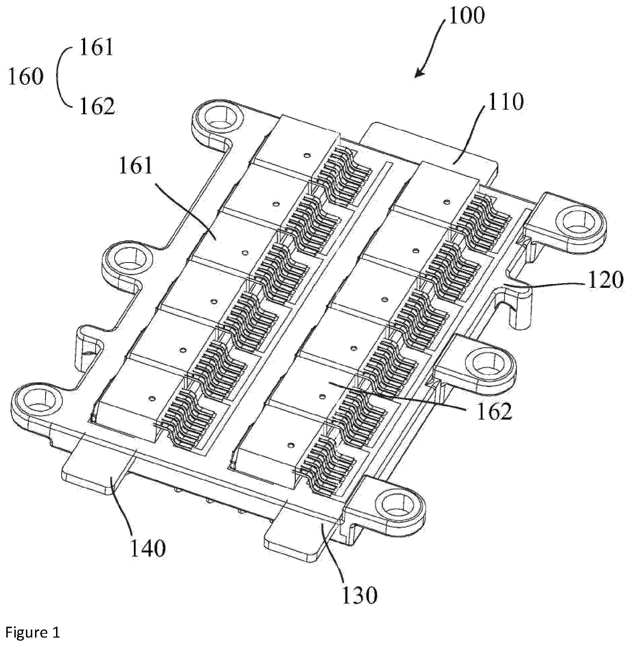

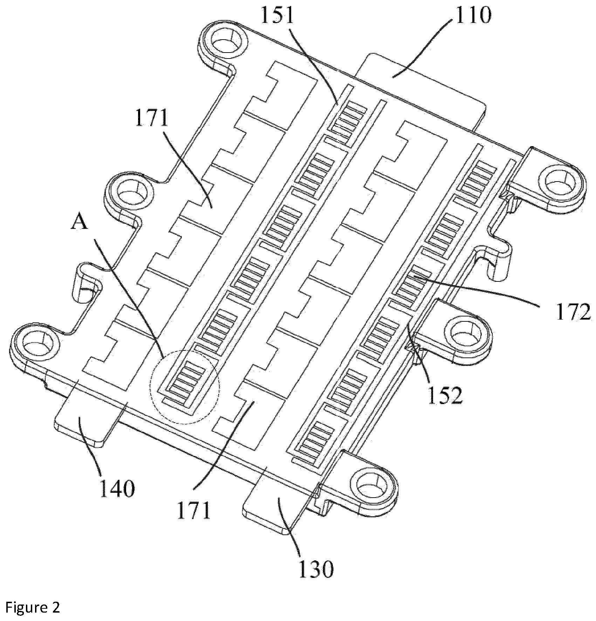

Referring to FIGS. 1 and 2, an embodiment provides a power module (power supply module) 100, mainly including:
a power chip 160 including upper bridge power chips 161 and lower bridge power chips 162, and a DC+ busbar 140, an AC busbar 110 and a DC- busbar 130 arranged substantially parallel to one another; where a plurality of upper bridge power chips 161 are linearly distributed between the DC+ busbar 140 and the AC busbar 110, and a plurality of lower bridge power chips 162 are linearly distributed between the AC busbar 110 and the DC- busbar 130, where the upper bridge power chips 161 and the lower bridge power chips 162 are equal in number; each upper bridge power chip 161 has a drain electrically connected to the DC+ busbar 140, a source electrically connected to the AC busbar 110, and a gate connected to the first gate busbar 151, where the first gate busbar 151 is immediately adjacent to a connection between the source and AC busbar 110; and each lower bridge power chip 162 has a drain electrically connected to the AC busbar 110, a source electrically connected to the DC- busbar 130, and a gate connected to a second gate busbar 152, where the second gate busbar 152 is immediately adjacent to a connection between the source and the DC- busbar 130.

In accordance with the claimed invention the DC+ busbar 140, the AC busbar 110 and the DC- busbar 130 are arranged substantially parallel to one another, and the upper bridge power chips 161 are linearly distributed (i.e., in a line) parallel to the DC+ busbar 140, etc., and similarly, the lower bridge power chips 162 are linearly distributed parallel to the DC+ busbar 140, etc. The upper bridge power chips 161 and the lower bridge power chips 162 are arranged in length directions of the busbars. This arrangement of elements makes the positions of the elements more regular and the structure more compact, and also simplifies the AC/DC connection method. Also, the first gate busbar 151 is immediately adjacent to the connection between the source and AC busbar 110, and the second gate busbar 152 is immediately adjacent to the connection between the source and DC- busbar 130, i.e., the gate busbars do not additionally take up more space, which further reduces the size of the power module 100 and makes a package size more integrated.

In accordance with the claimed invention, a plurality of drain pads 171 are arranged on the DC+ busbar 140, a drain bonding wire of each upper bridge power chip 161 being electrically connected to a corresponding drain pad 171; a plurality of source pads 172 are arranged on a side of the AC busbar 110 close to the upper bridge power chips 161, a source bonding wire of each upper bridge power chip 161 being electrically connected to a corresponding source pad 172, and a plurality of drain pads 171 are arranged on a side of the AC busbar 110 close to the lower bridge power chips 162, a drain bonding wire of each lower bridge power chip 162 being electrically connected to a corresponding drain pad 171; and a plurality of source pads 172 are arranged on the DC- busbar 130, a source bonding wire of each lower bridge power chip 162 being electrically connected to a corresponding source pad 172.

Bonding wires of a source and a drain of the power chip 160 are connected by pads to achieve more stable electrical connections and higher mechanical strength, such that the performance stability and reliability of the power module 100 in complex environment can be guaranteed. Using the pads as electrical connection means, which has a low contact resistance, can provide more efficient power transmission and thus is conducive to improving the efficiency of the power module 100.

In accordance with the claimed invention, each of the source pads 172 arranged on at least one of the AC busbar 110 and the DC- busbar 130 includes a plurality of welding blocks, the welding blocks of each source pad 172 and the bonding wires led out from the source of a corresponding power chip 160 are equal in number, and one of the bonding wires is electrically connected to each of the welding blocks.

Referring to FIG. 2, A represents one source pad 172, here the source pad is composed of 5 small welding blocks, and correspondingly, here the power chip 160 has 5 bonding wires led out from the source, and each bonding wire is electrically connected to one welding block. The plurality of welding blocks can better dissipate heat from a welding point and avoid welding failure or damage due to overheating of an individual welding point, thus making the welding more robust and more reliable.

In accordance with the claimed invention, J Z at least one of the first gate busbar 151 and the second gate busbar 152 includes one comb-shaped first sub-busbar 1501 and one comb-shaped second sub-busbar 1502. All comb teeth 1503 of the first sub-busbar 1501 are positioned on the same side, and all comb teeth 1503 of the second sub-busbar 1502 are positioned on the same side. The first sub-busbar 1501 and the second sub-busbar 1502 are arranged opposite to each other. Each source pad 172 is positioned between two adjacent comb teeth 1503 of the first sub-busbar 1501 and also positioned between two adjacent comb teeth 1503 of the second sub-busbar 1502.

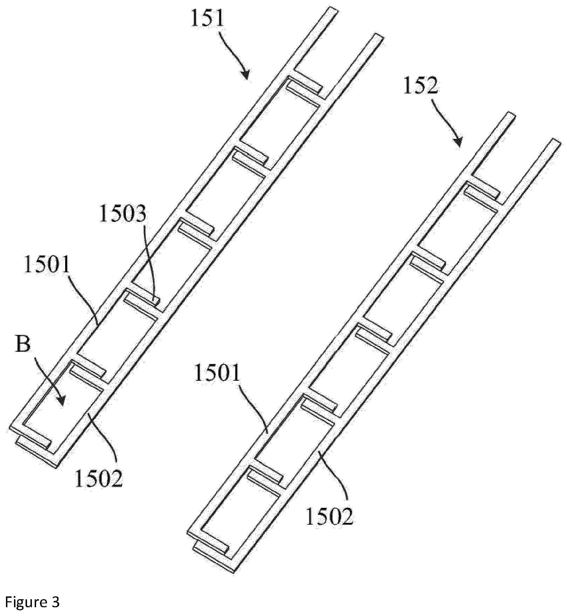

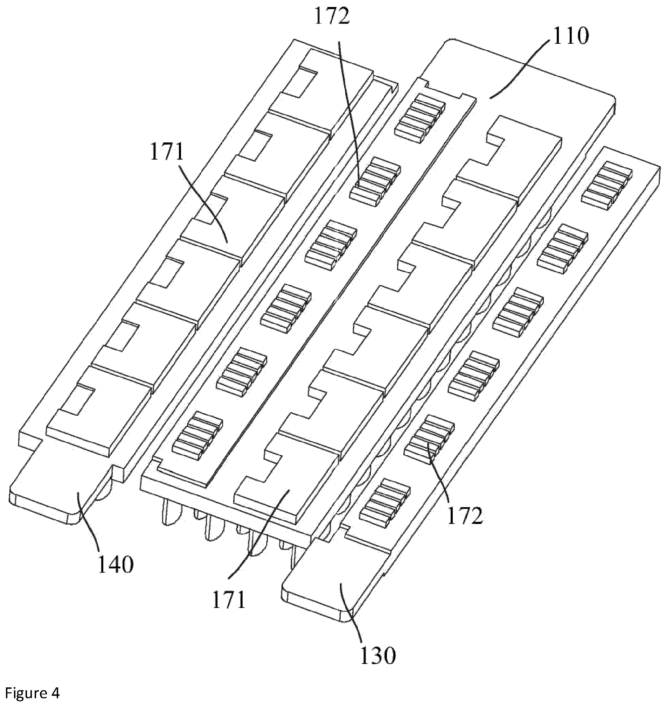

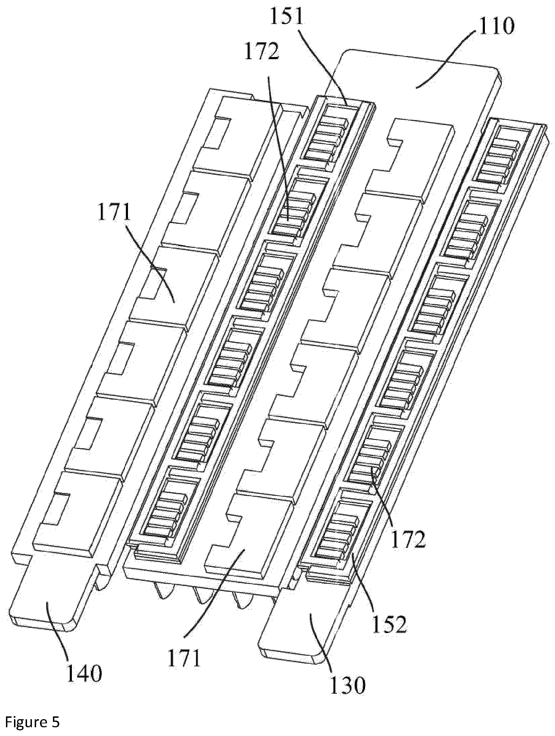

Referring to FIG. 3, in an example of the first gate busbar 151, the first sub-busbar 1501 with a plurality of comb teeth 1503 distributed thereon is arranged on the left, every two adjacent comb teeth 1503 may be equidistantly or non-equidistantly spaced, and each comb tooth 1503 is oriented to the right. The second sub-busbar 1502 with a plurality of comb teeth 1503 distributed thereon is arranged on the right side of the first gate busbar 151, every two adjacent comb teeth 1503 may be equidistantly or non-equidistantly spaced, and each comb tooth 1503 is oriented to the left. The two sub-busbars are arranged opposite to each other to form a plurality of accommodating spaces as shown at B in the figure. Referring to FIGS. 4 and 5, a source pad 172 may be accommodated at B in the figure. Therefore, the space occupied by the first gate busbar 151 can be reduced, which reduces the size of the power module 100.

Further, if the source pads 172 are small, the first sub-busbar 1501 and the second sub-busbar 1502 may be somewhat misaligned such that the first sub-busbar 1501 and the second sub-busbar 1502 are closer to each other, and the formed accommodating spaces may accommodate or adapt to the smaller source pads 172. Reference may be made to the structure of the first gate busbar 151 for the details of the second gate busbar 152, which will not be repeated herein.

In an example, each comb tooth 1503 of at least one of the first sub-busbar 1501 and the second sub-busbar 1502 is provided with a gate pad 173, and gate bonding wires of the power chip 160 are electrically connected to the gate pads 173, such that the electrical connection is more stable and the mechanical strength is higher, for which reference may be made to relevant descriptions of the performance when the aforementioned pads use welding blocks and which will not be repeated herein.

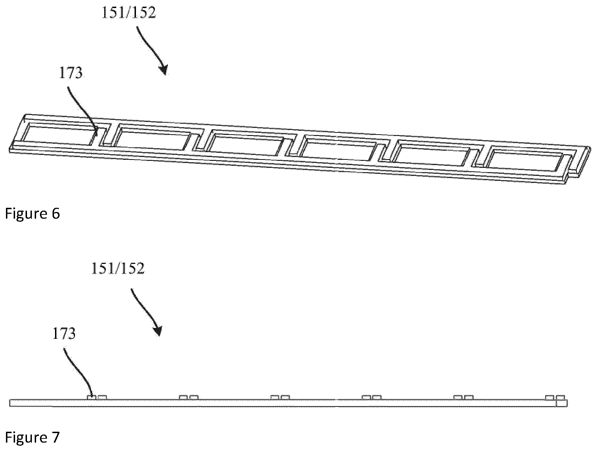

Referring to FIGS. 6 and 7, in this embodiment, pre-injection molding may be performed on the first gate busbar 151 and the second gate busbar 152 to cover areas to be insulated, with only areas that need to be metallically connected exposed.

In an example, the power module 100 further includes an enclosure 120, the enclosure 120 covering the power module 100 and exposing an external conductive area of a conductive element of the power module 100. It can be understood that covering the power module 100 with the enclosure 120 means that the enclosure 120 encloses other elements of the power module 100 since the enclosure 120 is also a part of the power module 100. In this embodiment, the enclosure 120 may be formed by means of injection molding. By way of example, the first gate busbar 151 and the second gate busbar 152 that are pre-injection-molded may be assembled to a busbar main body (mainly including a DC+ busbar, a DC- busbar and an AC busbar), the assembled busbar main body is injection-molded again to cover areas to be insulated and expose only areas to be electrically connected. The areas to be electrically connected are areas on the busbar main body that are connected to the source, the drain and the gate of the power chip 160.

In this embodiment, most circuit connections are embedded into a PCB, such that the power module 100 has lower stray inductance. In addition, since all the busbars and the power chip 160 are also embedded into the PCB, the circuit connections between the busbars and the power chip 160 are shortened, which can also reduce the inductance.

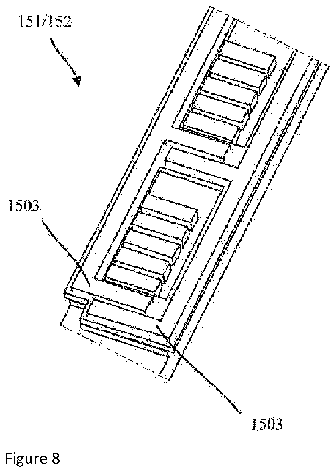

In an example, referring to FIG. 8, the comb teeth 1503 of the first sub-busbar 1501 are in interference fit with the comb teeth 1503 of the second sub-busbar 1502 to limit the movements of the first sub-busbar 1501 and the second sub-busbar 1502 in a planar direction, such that the structure of the gate busbar is more stable.

In an example, a heat dissipation structure 180 is further provided on a back surface of the power module 100. Further, an insulating resin layer (not shown in the figure) is provided on the back surface of the power module 100, and the heat dissipation structure 180 is arranged on a surface of the insulating resin layer.

The heat dissipation structure 180 is an important component which may effectively dissipate heat generated by the power module 100 to ensure normal operations of the power module 100. In this embodiment, the insulating resin layer is provided on the back surface of the power module 100, and the insulating resin layer is not an insulating layer inside the PCB, such that the heat dissipation performance of the power module 100 can be improved.

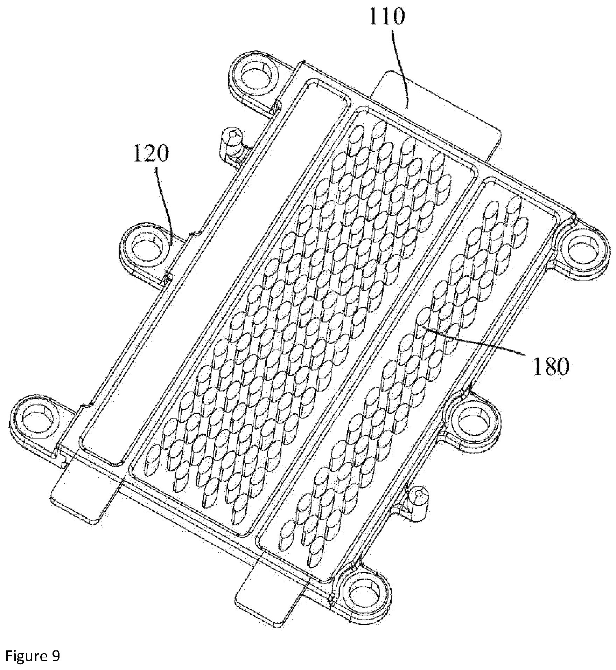

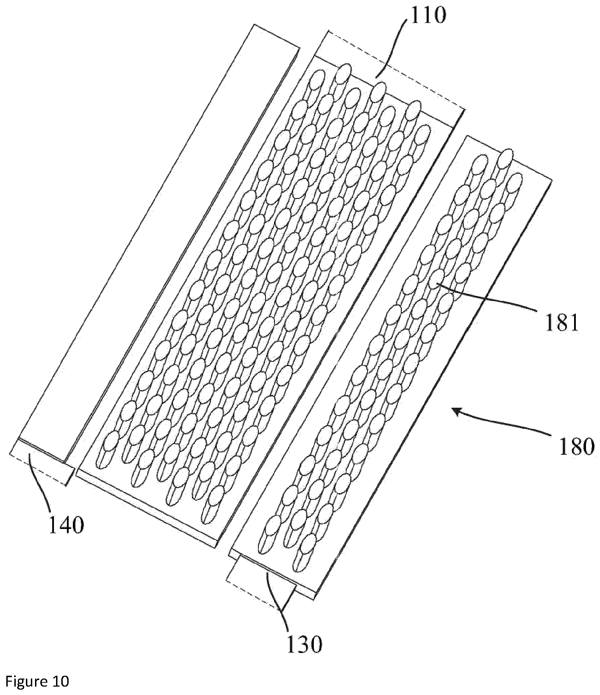

In an example, referring to FIGS. 9 and 10, the heat dissipation structure 180 is a finned heat dissipation structure. The finned heat dissipation structure is the heat dissipation structure 180 with fins 181, and the fins 181 are core components of the finned heat dissipation structure and are generally made of a metallic material, such as aluminum alloy and copper, which significantly improves the heat dissipation performance. The fins 181 may be in the form of flat sheets, wavy sheets or corrugated sheets, etc., which will not be listed herein, and mainly function to increase the surface area of the heat dissipation structure 180 so as to improve the heat dissipation effect.

In the power module 100 provided in this embodiment, the DC+ busbar 140, the AC busbar 110 and the DC- busbar 130 are arranged substantially parallel to one another. Each upper bridge power chip 161 has the drain electrically connected to the DC+ busbar 140, the source electrically connected to the AC busbar 110 and the gate connected to the first gate busbar 151, where the first gate busbar 151 is immediately adjacent to the connection between the source and the AC busbar 110. Each lower bridge power chip 162 has the drain electrically connected to the AC busbar 110, the source electrically connected to the DC- busbar 130 and the gate connected to the second gate busbar 152, where the second gate busbar 152 is immediately adjacent to the connection between the source and the DC- busbar 130. Therefore, the power chip 160 can be arranged compactly, a distance between elements is reduced, and the size of the power module 100 can be ultimately reduced.

## Claims

1. A power module (100), comprising:
a power chip (160), the power chip (160) comprising upper bridge power chips (161) and lower bridge power chips (162), and a DC+ busbar (140), an AC busbar (110) and a DC- busbar (130) being arranged substantially parallel to one another; wherein
a plurality of upper bridge power chips (161) are linearly distributed parallel to the DC+ busbar (140) and the AC busbar (110), and a plurality of lower bridge power chips (162) are linearly distributed parallel to the AC busbar (110) and the DC- busbar (130),
wherein the upper bridge power chips (161) and the lower bridge power chips (162) are equal in number;
each of the upper bridge power chips (161) has a drain electrically connected to the DC+ busbar (140), a source electrically connected to the AC busbar (110) and a gate connected to a first gate busbar (151); wherein the first gate (151) busbar is immediately adjacent to a connection between the source and the AC busbar (110); and
each of the lower bridge power chips (162) has a drain electrically connected to the AC busbar (110), a source electrically connected to the DC- busbar (130) and a gate connected to a second gate busbar (152); wherein the second gate busbar (152) is immediately adjacent to a connection between the source and the DC- busbar (130) ,
wherein
a plurality of drain pads (171) are arranged on the DC+ busbar (140), a drain bonding wire of each of the upper bridge power chips (161) being electrically connected to a corresponding drain pad (171);
a plurality of source pads (172) are arranged on a side of the AC busbar (110) close to the upper bridge power chips (161), a source bonding wire of each of the upper bridge power chips (161) being electrically connected to a corresponding source pad (172);
a plurality of drain pads (171) are arranged on a side of the AC busbar (110) close to the lower bridge power chips (162), a drain bonding wire of each of the lower bridge power chips (162) being electrically connected to a corresponding drain pad (171); and
a plurality of source pads (172) are arranged on the DC- busbar (130), a source bonding wire of each of the lower bridge power chips (162) being electrically connected to a corresponding source pad (172), wherein
each of the source pads (172) arranged on at least one of the AC busbar (110) and the DC-busbar (130) comprises a plurality of welding blocks, the welding blocks of each of the source pads (172) and the bonding wires led out from the source of a corresponding power chip (160) are equal in number, and one of the bonding wires is electrically connected to each of the welding blocks, wherein
at least one of the first gate busbar (151) and the second gate busbar (152) comprises one comb-shaped first sub-busbar (1501) and one comb-shaped second sub-busbar (1502);
all comb teeth (1503) of the first sub-busbar (1501) are positioned on the same side, and all comb teeth (1503) of the second sub-busbar (152) are positioned on the same side; and the first sub-busbar (1501) and the second sub-busbar (1502) are arranged opposite to each other, and each of the source pads (172) is positioned between two adjacent comb teeth (1503) of the first sub-busbar (1501) and also positioned between two adjacent comb teeth (1503) of the second sub-busbar (1502).

2. The power module (100) of claim 1, wherein
the comb teeth (1503) of the first sub-busbar (1501) are in interference fit with the comb teeth (1503) of the second sub-busbar (1502).

3. The power module (100) of claim 1, wherein
each comb tooth (1503) of at least one of the first sub-busbar (1501) and the second sub-busbar (1502) is provided with a gate pad (173), and a gate bonding wire of the power chip (160) is electrically connected to the gate pad (173).

4. The power module (100) of any one of claims 1-3,
further comprising an enclosure (120), the enclosure (120) covering the power module (100) and exposing an external conductive area of a conductive element of the power module (100).

5. The power module (100) of claim 4, wherein a heat dissipation structure (180) is further provided on a back surface of the power module (100).

6. The power module (100) of claim 5, wherein an insulating resin layer is provided on the back surface of the power module (100), and the heat dissipation (180) structure is arranged on a surface of the insulating resin layer.

7. The power module (100) of claim 5, wherein the heat dissipation structure (180) is a finned heat dissipation structure (180).

## Patentansprüche

1. Leistungsmodul (100), umfassend:
einen Leistungs-Chip (160), wobei der Leistungs-Chip (160) Oberbrücken-Leistungs-Chips (161) und Unterbrücken-Leistungs-Chips (162) umfasst, und eine "DC+"-Sammelschiene (140), eine AC-Sammelschiene (110) und eine "DC-"-Sammelschiene (130), die im Wesentlichen parallel zueinander angeordnet sind; wobei
mehrere Oberbrücken-Leistungschips (161) linear parallel zu der "DC+"-Sammelschiene (140) und zu der AC-Sammelschiene (110) verteilt sind und mehrere Unterbrücken-Leistungschips (162) linear parallel zu der AC-Sammelschiene (110) und zu der "DC-"-Sammelschiene (130) verteilt sind,
wobei die Oberbrücken-Leistungs-Chips (161) und die Unterbrücken-Leistungs-Chips (162) in gleicher Anzahl vorhanden sind;
jeder der Oberbrücken-Leistungs-Chips (161) aufweist: einen Drain, der elektrisch mit der "DC+"-Sammelschiene (140) verbunden ist, eine Source, die elektrisch mit der AC-Sammelschiene (110) verbunden ist, und ein Gate, das mit einer ersten Gate-Sammelschiene (151) verbunden ist; wobei sich die erste Gate-Sammelschiene (151) unmittelbar neben einer Verbindung zwischen der Source und der AC-Sammelschiene (110) befindet; und
jeder der Unterbrücken-Leistungs-Chips (162) aufweist: einen Drain, der elektrisch mit der AC-Sammelschiene (110) verbunden ist, eine Source, die elektrisch mit der "DC-"-Sammelschiene (130) verbunden ist, und ein Gate, das mit einer zweiten Gate-Sammelschiene (152) verbunden ist; wobei sich die zweite Gate-Sammelschiene (152) unmittelbar neben einer Verbindung zwischen der Source und der "DC-"-Sammelschiene (130) befindet,
wobei
mehrere Drain-Pads (171) auf der "DC+"-Sammelschiene (140) angeordnet sind, wobei ein Drain-Bondungsdraht jedes der Oberbrücken-Leistungs-Chips (161) elektrisch mit einem entsprechenden Drain-Pad (171) verbunden ist;
mehrere Source-Pads (172) auf einer Seite der AC-Sammelschiene (110) nahe den Oberbrücken-Leistungs-Chips (161) angeordnet sind, wobei ein Source-Bondungsdraht jedes der Oberbrücken-Leistungs-Chips (161) elektrisch mit einem entsprechenden Source-Pad (172) verbunden ist;
mehrere Drain-Pads (171) auf einer Seite der AC-Sammelschiene (110) nahe den Unterbrücken-Leistungschips (162) angeordnet sind, wobei ein Drain-Bondungsdraht jedes der Unterbrücken-Leistungschips (162) elektrisch mit einem entsprechenden Drain-Pad (171) verbunden ist; und mehrere Source-Pads (172) auf der "DC-"Sammelschiene (130) angeordnet sind, wobei ein Source-Bondungsdraht jedes der Unterbrücken-Leistungschips (162) elektrisch mit einem entsprechenden Source-Pad (172) verbunden ist, wobei
jedes der Source-Pads (172), die auf mindestens einer der AC-Sammelschiene (110) und der "DC-"-Sammelschiene (130) angeordnet sind, mehrere Schweißblöcke umfasst, die Schweißblöcke jedes der Source-Pads (172) und die Bondungsdrähte, die aus der Source eines entsprechenden Leistungs-Chips (160) herausgeführt sind, in gleicher Anzahl vorhanden sind, und einer der Bondungsdrähte elektrisch mit jedem der Schweißblöcke verbunden ist, wobei mindestens eine der ersten Gate-Sammelschiene (151) und der zweiten Gate-Sammelschiene (152) eine kammförmige erste Teil-Sammelschiene (1501) und eine kammförmige zweite Teil-Sammelschiene (1502) umfasst;
alle Kammzähne (1503) der ersten Teil-Sammelschiene (1501) auf derselben Seite positioniert sind und alle Kammzähne (1503) der zweiten Teil-Sammelschiene (1502) auf derselben Seite positioniert sind; und die erste Teil-Sammelschiene (1501) und die zweite Teil-Sammelschiene (1502) einander gegenüber angeordnet sind und jedes der Source-Pads (172) zwischen zwei benachbarten Kammzähnen (1503) der ersten Teil-Sammelschiene (1501) angeordnet ist und außerdem zwischen zwei benachbarten Kammzähnen (1503) der zweiten Teil-Sammelschiene (1502) angeordnet ist.

2. Leistungsmodul (100) nach Anspruch 1, wobei
sich die Kammzähne (1503) der ersten Teil-Sammelschiene (1501) in einer Presspassung mit den Kammzähnen (1503) der zweiten Teil-Sammelschiene (1502) befinden.

3. Leistungsmodul (100) nach Anspruch 1, wobei
jeder Kammzahn (1503) mindestens einer der ersten Teil-Sammelschiene (1501) und der zweiten Teil-Sammelschiene (1502) mit einem Gate-Pad (173) versehen ist und ein Gate-Bondungsdraht des Leistungs-Chips (160) elektrisch mit dem Gate-Pad (173) verbunden ist.

4. Leistungsmodul (100) nach einem der Ansprüche 1-3,
des Weiteren umfassend ein Gehäuse (120), wobei das Gehäuse (120) das Leistungsmodul (100) bedeckt und einen externen leitfähigen Bereich eines leitfähigen Elements des Leistungsmoduls (100) freilegt.

5. Leistungsmodul (100) nach Anspruch 4, wobei des Weiteren eine Wärmeableitungsstruktur (180) auf einer Rückseite des Leistungsmoduls (100) bereitgestellt ist.

6. Leistungsmodul (100) nach Anspruch 5, wobei eine isolierende Harzschicht auf der Rückseite des Leistungsmoduls (100) bereitgestellt ist und die Wärmeableitungsstruktur (180) auf einer Fläche der isolierenden Harzschicht angeordnet ist.

7. Leistungsmodul (100) nach Anspruch 5, wobei die Wärmeableitungsstruktur (180) eine mit Finnen versehene Wärmeableitungsstruktur (180) ist.

## Revendications

1. Module de puissance (100), comprenant :
une puce de puissance (160), la puce de puissance (160) comprenant des puces de puissance de pont supérieur (161) et des puces de puissance de pont inférieur (162), et une barre omnibus CC+ (140), une barre omnibus CA (110) et une barre omnibus CC- (130) agencées de manière substantiellement parallèle les unes aux autres ; dans lequel une pluralité de puces de puissance de pont supérieur (161) sont distribuées de manière linéairement parallèle à la barre omnibus CC+ (140) et à la barre omnibus AC (110), et une pluralité de puces de puissance de pont inférieur (162) sont distribuées de manière linéairement parallèle à la barre omnibus AC (110) et à la barre omnibus CC- (130) ;
les puces de puissance de pont supérieur (161) et les puces de puissance de pont inférieur (162) sont en nombre égal ;
chacune des puces de puissance de pont supérieur (161) comporte un drain connecté électriquement à la barre omnibus CC+ (140), une source connectée électriquement à la barre omnibus AC (110) et une grille connectée à une première barre omnibus de grille (151) ;
la première barre omnibus de grille (151) est immédiatement adjacente à une connexion entre la source et la barre omnibus CA (110) ;
chacune des puces de puissance de pont inférieur (162) comporte un drain connecté électriquement à la barre omnibus CA (110), une source connectée électriquement à la barre omnibus CC- (130) et une grille connectée à une deuxième barre omnibus de grille (152) ;
la deuxième barre omnibus de grille (152) est immédiatement adjacente à une connexion entre la source et la barre omnibus CC- (130) ;
une pluralité de plots de drain (171) sont agencés sur la barre omnibus CC+ (140), un fil de liaison de drain de chacune des puces de puissance de pont supérieur (161) étant connecté électriquement à un plot de drain (171) correspondant ;
une pluralité de plots de source (172) sont agencés sur un côté de la barre omnibus CA (110) proche des puces de puissance de pont supérieur (161), un fil de liaison de source de chacune des puces de puissance de pont supérieur (161) étant connecté électriquement à un plot de source (172) correspondant ;
une pluralité de plots de drain (171) sont agencés sur un côté de la barre omnibus CA (110) proche des puces de puissance de pont inférieur (162), un fil de liaison de drain de chacune des puces de puissance de pont inférieur (162) étant connecté électriquement à un plot de drain (171) correspondant ;
une pluralité de plots de source (172) sont agencés sur la barre omnibus CC- (130), un fil de liaison de source de chacune des puces de puissance de pont inférieur (162) étant connecté électriquement à un plot de source (172) correspondant ;
chacun des plots de source (172) agencés sur au moins une barre parmi la barre omnibus CA (110) et la barre omnibus CC- (130) comprend une pluralité de blocs de brasure, les blocs de brasure de chacun des plots de source (172) et les fils de liaison sortant de la source d'une puce de puissance (160) correspondante sont en nombre égal, et l'un des fils de liaison est connecté électriquement à chacun des blocs de brasure ;
au moins une barre parmi la première barre omnibus de grille (151) et la deuxième barre omnibus de grille (152) comprend une première sous-barre omnibus en forme de peigne (1501) et une deuxième sous-barre omnibus en forme de peigne (1502) ;
toutes les dents de peigne (1503) de la première sous-barre omnibus (1501) sont positionnées du même côté, et toutes les dents de peigne (1503) de la deuxième sous-barre omnibus (1502) sont positionnées du même côté ; et
la première sous-barre omnibus (1501) et la deuxième sous-barre omnibus (1502) sont agencées face à face, et chacun des plots de source (172) est positionné entre deux dents de peigne adjacentes (1503) de la première sous-barre omnibus (1501) et également entre deux dents de peigne adjacentes (1503) de la deuxième sous-barre omnibus (1502).

2. Module de puissance (100) selon la revendication 1, dans lequel
les dents de peigne (1503) de la première sous-barre omnibus (1501) sont frettées avec les dents de peigne (1503) de la deuxième sous-barre omnibus (1502).

3. Module de puissance (100) selon la revendication 1, dans lequel
chaque dent de peigne (1503) d'au moins une barre parmi la première sous-barre omnibus (1501) et la deuxième sous-barre omnibus (1502) est pourvue d'un plot de grille (173), et un fil de liaison de grille de la puce de puissance (160) est connecté électriquement au plot de grille (173).

4. Module de puissance (100) selon l'une quelconque des revendications 1 à 3,
comprenant en outre une enceinte (120), l'enceinte (120) recouvrant le module de puissance (100) et exposant une zone conductrice externe d'un élément conducteur du module de puissance (100).

5. Module de puissance (100) selon la revendication 4, dans lequel une structure de dissipation de chaleur (180) est en outre pourvue sur une surface arrière du module de puissance (100).

6. Module de puissance (100) selon la revendication 5, dans lequel une couche de résine isolante est pourvue sur la surface arrière du module de puissance (100), et la structure de dissipation de chaleur (180) est agencée sur une surface de la couche de résine isolante.

7. Module de puissance (100) selon la revendication 5, dans lequel la structure de dissipation de chaleur (180) est une structure de dissipation de chaleur à ailettes (180).
